# EUROPEAN PATENT APPLICATION

(11) **EP 4 561 306 A1**
(43) Date of publication of application: **28.05.2025**
(21) Application number: 24213373.4
(22) Date of filing: 15.11.2024
(51) Int. Cl.: H10H 29/24, H10H 29/32, H10H 29/80, H10H 29/85, H10H 29/855

(54) **TRANSMISSION TYPE DISPLAY**

(30) Priority: 24.11.2023 JP 2023199050
(71) Applicant: Alps Alpine Co., Ltd., Ota-ku, Tokyo 145-8501 (JP)
(72) Inventor: Yoshii, Katsumasa, Iwaki, Fukushima (JP)
(74) Representative: Schmitt-Nilson Schraud Waibel Wohlfrom Patentanwälte Partnerschaft mbB

(57) **Abstract**

A transmission type display is provided, wherein a plurality of light sources are arranged between a plurality of sets of electrodes arranged in an array on a transparent substrate, and a plurality of openings where the electrodes are not arranged are provided, so that light is transmittable through the plurality of openings. A light shielding layer is arranged in a target region including a region shielding an optical path in a direction from a portion of a back surface of the light source facing a gap between the electrodes toward the transparent substrate.

## Description

The present invention relates to a transmission type display, and is particularly suitable for use in a transmission type display in which a plurality of light sources are arranged between a plurality of sets of electrodes arranged in an array on a transparent substrate, and a plurality of openings are provided in which no electrodes are arranged so that light is transmittable through the plurality of openings.

Conventionally, unlike a general display, a transmission type display in which the area behind the display can be seen through, is known. In the transmission type display, a plurality of light sources are arranged in an array on a transparent substrate and a plurality of openings, where electrodes and the like are not arranged, are provided so that light is transmittable from the back side to the front side of the display through the openings. The ratio of the area of the openings occupying the area of one pixel is referred to as the aperture ratio, and the larger the aperture ratio, the more light from the background can be taken in, and the display can be almost transparent in appearance.

There are various types of transmission type displays, and among them, a transmissive LED display is expected to be applied to various applications because it can achieve a high transmittance of 70% or more. When a transmissive LED display is constructed, it is preferable to use a technology referred to as micro-LED, which is made by miniaturizing LEDs used as light sources and arranging them in an array. A display using micro-LED is disclosed in JP 2021-052156 A, JP 2022-093393 A, and WO 2023-127585 A, for example.

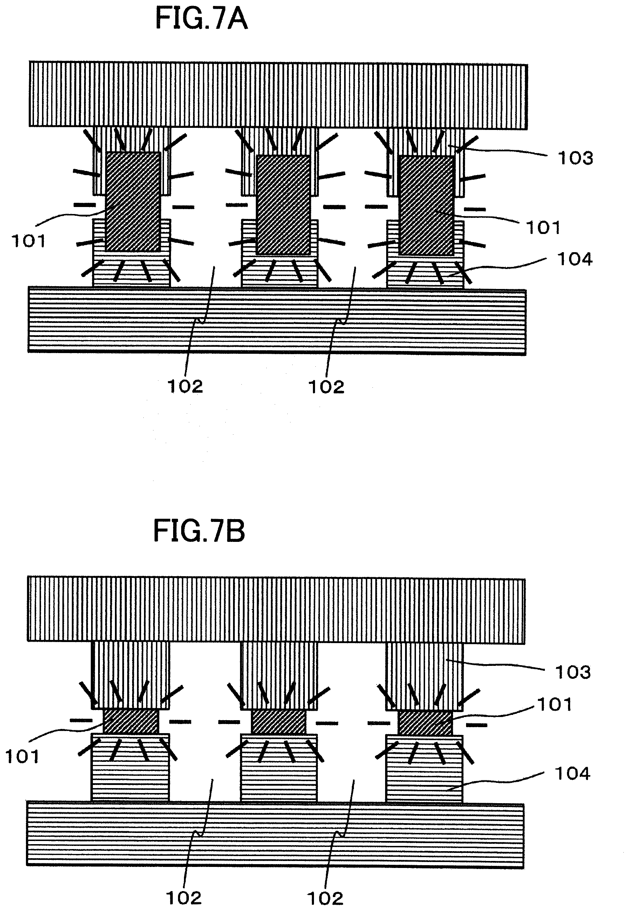

FIGS. 7A and 7B are simplified diagrams illustrating the structure of the light-emitting portion of the transmissive LED display. FIG. 7A illustrates a state in which the light-emitting portion of the transmissive LED display is viewed from the front side, and FIG. 7B illustrates a state in which the light-emitting portion of the transmissive LED display is viewed from the back side. As illustrated in FIGS. 7A and 7B, a plurality of LEDs 101 are arranged in an array, and a plurality of openings 102 are arranged in an array so as to be adjacent to the plurality of LEDs 101. The plurality of LEDs 101 are each arranged between an anode electrode 103 and a cathode electrode 104.

However, in the transmissive LED display configured in this way, there has been a problem that light emitted from the LED 101 for projecting information on the front side leaks to the back side through a gap between the anode electrode 103 and the cathode electrode 104. That is, as illustrated in FIG. 7B, when the transmissive LED display is viewed from the back side, a part of the LED 101 is visible through a gap between the anode electrode 103 and the cathode electrode 104. In the transmissive LED display, not only the substrate arranged on the front side of the LED 101 is made of a transparent substrate, but also the substrate arranged on the back side of the LED 101 is made of a transparent substrate. Therefore, when the LED 101 is turned on, light leaks from the back side of the LED 101 to the back side of the display through a gap between the electrodes 103, 104.

An object of the present invention is to reduce light emitted when a light source is turned on from leaking to the back surface of the display in a transmission type display.

The present disclosure relates to a transmission type display according to the appended claims. Embodiments are disclosed in the dependent claims. According to an embodiment, in a transmission type display, a plurality of light sources are arranged between a plurality of sets of electrodes arranged in an array on a transparent substrate, and a plurality of openings where the electrodes are not arranged are provided, so that light is transmittable through the plurality of openings, wherein a light shielding layer is arranged in a target region including a region shielding an optical path in a direction from a portion of a back surface of the light source facing a gap between the electrodes toward the transparent substrate.

Other objects and further features of the present invention will be apparent from the following detailed description when read in conjunction with the accompanying drawings, in which:
FIG. 1 is a diagram illustrating a configuration example of a light-emitting structure with leakage reducing function applied to a transmissive LED display according to an embodiment;
FIG. 2A is a diagram schematically illustrating a conventional light-emitting structure, and FIG. 2B is a diagram schematically illustrating the light shielding effect of the light-emitting structure with leakage reducing function according to an embodiment;
FIG. 3 is a diagram schematically illustrating an example of a manufacturing process of the light-emitting structure with leakage reducing function according to an embodiment;
FIG. 4A is a diagram schematically illustrating an example of an array arrangement of a conventional light-emitting structure, and FIG. 4B is a diagram schematically illustrating an example of an array arrangement of the light-emitting structures with leakage reducing function according to an embodiment;
FIG. 5 is a diagram schematically illustrating another example of an array arrangement of a light-emitting structure with leakage reducing function according to an embodiment;
FIGS. 6A to 6D are diagrams illustrating a modified example of a light-emitting structure with leakage reducing function provided with a light-shielding layer according to an embodiment; and
FIGS. 7A and 7B are diagrams illustrating the structure of a light-emitting portion of a transmissive LED display.

According to aspects of the present invention configured as described above, in the transmission type display, the light, which is emitted from the back surface of the light source in a direction toward the transparent substrate when the light source is turned on, is shielded by the light shielding layer, and, therefore, leakage of light emitted from the light source to the back surface of the display can be reduced.

Hereinafter, embodiments of the present invention will be described with reference to the drawings. The transmission type display of the present embodiment is a transmission type display in which a plurality of light sources are arranged between a plurality of sets of electrodes arranged in an array on a transparent substrate, and a plurality of openings in which no electrodes are arranged are provided so that light is transmittable through the plurality of openings. As a result, the background light is transmitted from the back surface of the display to the front surface, and the area behind the display is seen through from the front side.

In the present embodiment, a structure for reducing light leakage to the back surface is applied to the light-emitting structure of a transmissive LED display using a micro-LED element as an example of a light source. In the following description, the term "light-emitting structure with leakage reducing function" refers to the light-emitting structure including the light leakage reducing structure of the present embodiment, and is distinguished from the light-emitting structure not including the light leakage reducing structure.

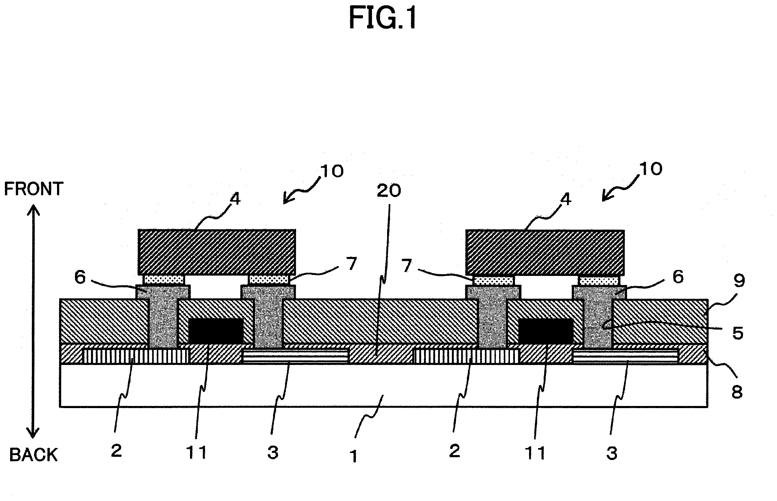

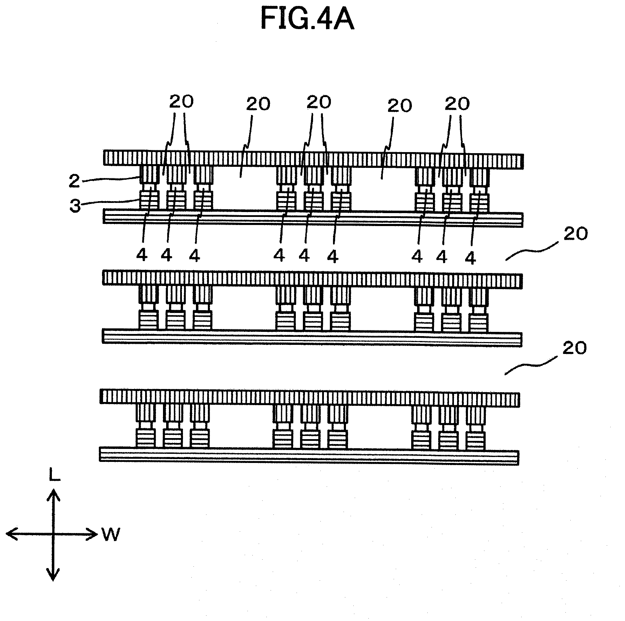

FIG. 1 is a diagram illustrating a configuration example of a light-emitting structure with leakage reducing function 10 applied to a transmissive LED display according to an embodiment. FIG. 1 illustrates a cross-sectional structure of the light-emitting structure with leakage reducing function 10 when the transmissive LED display is viewed from the side, in which the upper part of the figure is the front surface of the display and the lower part of the figure is the back surface of the display. In FIG. 1, two light-emitting structures with leakage reducing function 10 are illustrated in juxtaposition, but actually, more light-emitting structures with leakage reducing function 10 are arranged in an array (see FIGS. 4A to 5 described later).

As illustrated in FIG. 1, one light-emitting structure with leakage reducing function 10 has one set including an anode electrode 2 and a cathode electrode 3 arranged at a predetermined interval on a transparent substrate 1, and an LED 4 arranged between the anode electrode 2 and the cathode electrode 3 and electrically connected to the electrodes. In the example of FIG. 1, two electrode pads 6 are arranged in two contact holes 5 formed in two insulating layers 8 and 9 on the anode electrode 2 and the cathode electrode 3, and the LED 4 is mounted by a conductive adhesive 7 formed on the electrode pads 6.

An opening 20 in which the anode electrode 2 and the cathode electrode 3 are not arranged is provided between two adjacent light-emitting structures with leakage reducing function 10. Through the opening 20, light is transmittable from the back surface to the front surface of the transmissive LED display, whereby the area behind the transmissive LED display can be seen through from the front side.

In the present embodiment, a light-shielding layer 11 is provided for the light-emitting structure configured as described above. This light-shielding layer 11 is a light leakage reducing structure. The light-shielding layer 11 is arranged in a target region including a region for shielding the optical path in a direction from a portion of the back surface of the LED 4 facing the gap between the anode electrode 2 and the cathode electrode 3 toward the transparent substrate 1. In the example of FIG. 1, the light-shielding layer 11 is arranged in a target region including a region for shielding the optical path and covering the gap between the anode electrode 2 and the cathode electrode 3 on the front side of the gap.

The light-shielding layer 11 preferably has a high light shielding property so that the light-shielding layer 11 can shield even high-energy light emission. For example, the optical density (OD value), which is an index representing the amount of light transmission (transmittance), is preferably set to be "3" or more (transmittance is 0.1% or less). This is in consideration of the fact that the standard OD value of the black matrix formed to prevent light leakage and RGB color mixing in the backlight of the liquid crystal display device is set to be approximately "3".

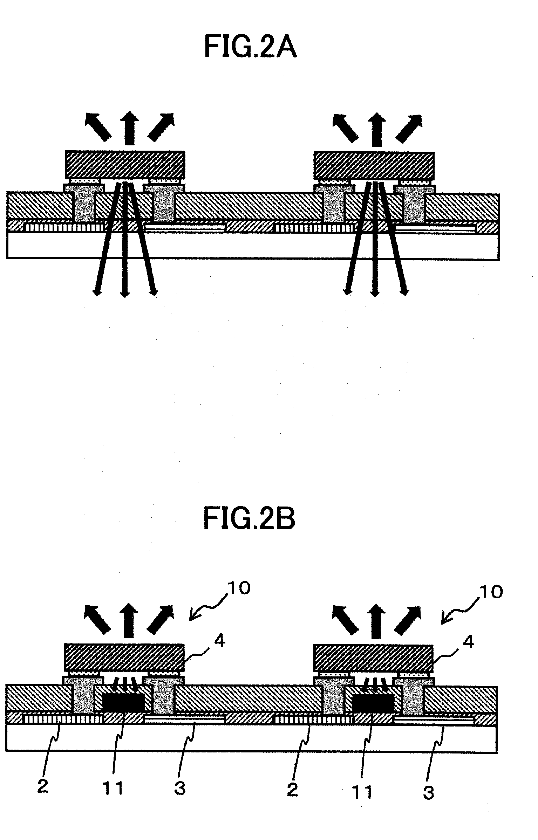

FIGS. 2A and 2B are diagrams schematically illustrating the light shielding effect of the light-emitting structure with leakage reducing function 10 according to the present embodiment configured as described above in comparison with a conventional light-emitting structure. FIG. 2A illustrates a conventional light-emitting structure, and FIG. 2B illustrates the light-emitting structure with leakage reducing function 10 according to the present embodiment. As illustrated in FIGS. 2A and 2B, when the LED 4 is turned on, light is emitted not only from the front surface but also from the back surface of the LED 4.

In the case of the conventional light-emitting structure illustrated in FIG. 2A, light emitted from the back surface of the LED 4 in the direction toward the transparent substrate 1 leaks through the gap between the anode electrode 2 and the cathode electrode 3 to the back surface of the transparent substrate 1. In contrast, in the case of the light-emitting structure with leakage reducing function 10 according to the present embodiment illustrated in FIG. 2B, light emitted from the back surface of the LED 4 in the direction toward the transparent substrate 1 is shielded by the light-shielding layer 11 arranged so as to cover the gap between the anode electrode 2 and the cathode electrode 3. Therefore, light emitted from the back surface of the LED 4 is substantially prevented or prevented from leaking through the gap between the anode electrode 2 and the cathode electrode 3 to the back surface of the transparent substrate 1.

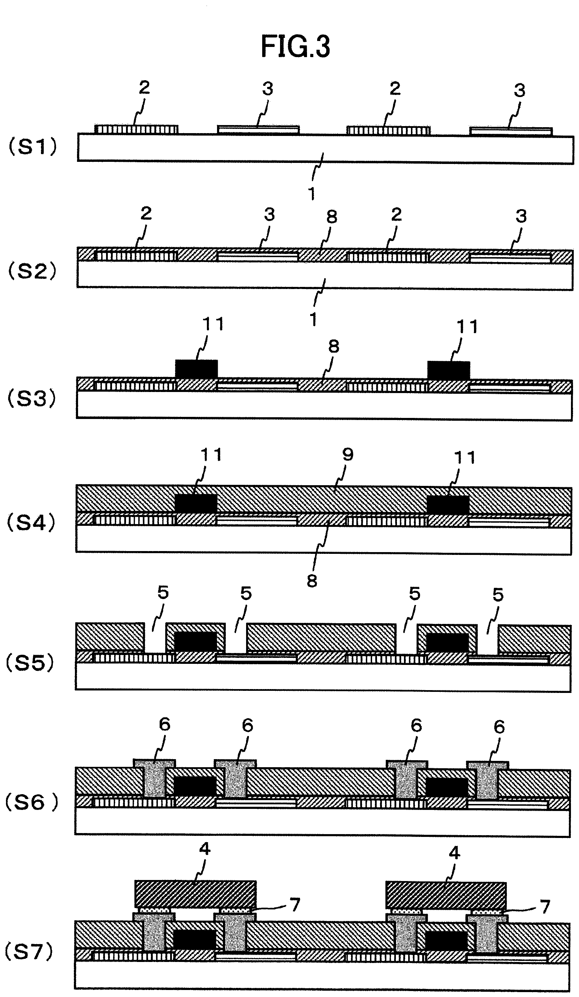

FIG. 3 is a diagram illustrating an example of a manufacturing process of the light-emitting structure with leakage reducing function 10 illustrated in FIG. 1. Note that the materials and steps described below are only examples, and are not limited thereto.

First, the anode electrode 2 and the cathode electrode 3 are formed on the transparent substrate 1 (step S1). As the materials of the anode electrode 2 and the cathode electrode 3, for example, Au, Ag, Cu, AgMg, Al, ITO, and the like can be used. As the process, a photolithography process is mainly used. The arrangement of the anode electrode 2 and the cathode electrode 3 is not limited to a simple matrix or an active matrix, but may be an irregular arrangement.

Next, a first insulating layer 8 is formed on the transparent substrate 1 so as to cover the anode electrode 2 and the cathode electrode 3 by vapor deposition, sputtering, or spin coating (step S2). As the material of the first insulating layer 8, for example, SiNx, SiOx, acrylic resin, or the like can be used.

Next, the light-shielding layer 11 is formed on the first insulating layer 8 in a target region covering the gap between the anode electrode 2 and the cathode electrode 3 (step S3). For example, a light-shielding material is applied on the first insulating layer 8 by vapor deposition or spin coating, and the light-shielding layer 11 is formed on the target region covering the gap between the anode electrode 2 and the cathode electrode 3 by a photolithography process. As the light-shielding material, for example, a photosensitive resin containing a black pigment, chromium oxide, or the like can be used.

Next, a second insulating layer 9 is formed on the first insulating layer 8 by vapor deposition, sputtering, spin coating, or the like so as to cover the light-shielding layer 11 (step S4). As the material of the second insulating layer 9, for example, SiNx, SiOx, acrylic resin, or the like can be used. Because the second insulating layer 9 also serves the role of planarization, it is preferable that the film is thicker than the first insulating layer 8.

Next, a contact hole 5 is formed on the anode electrode 2 and the cathode electrode 3 by a photolithography process and etching (step S5). Further, an electrode pad 6 is formed in the contact hole 5 mainly by a photolithography process, and the electrode pad 6 is electrically connected to the anode electrode 2 and the cathode electrode 3 (step S6). For example, Au, Ag, Cu, AgMg, Al, ITO, or the like can be used as the material of the electrode pad 6.

Finally, after the conductive adhesive 7 is formed on the electrode pad 6, the LED 4 is mounted (step S7). As the conductive adhesive 7, for example, solder, ACF (anisotropic conductive film), or a material in which conductive particles are dispersed in resin can be used. After the LED 4 is placed in the correct position, mounting is performed by reflow soldering in the case of using solder, and by pressurization and heating in the case of using other materials, to solidify the LED 4.

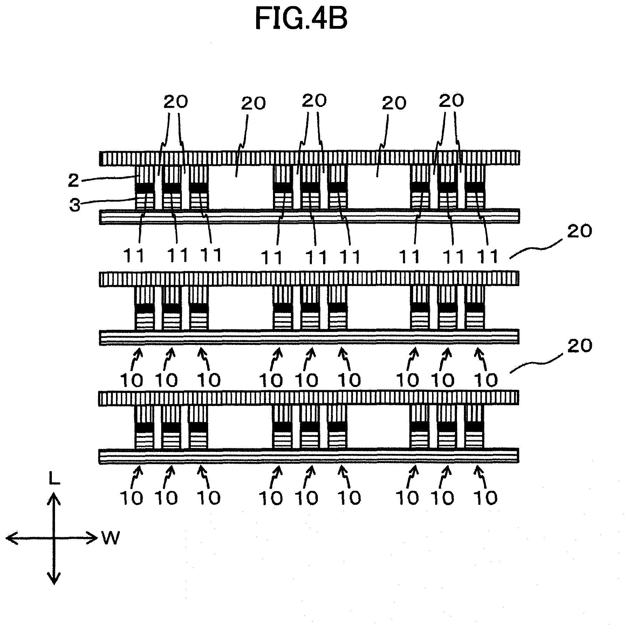

FIGS. 4A and 4B is a diagram schematically illustrating an example of an array arrangement of the light-emitting structures with leakage reducing function 10 in comparison with an array arrangement of a conventional light-emitting structure. FIG. 4A is an array arrangement of a conventional light-emitting structure, and illustrates a state in which the light-emitting structure is viewed from the back side. FIG. 4B is an array arrangement of the light-emitting structures with leakage reducing function 10, and illustrates a state in which the light-emitting structures with leakage reducing function 10 are viewed from the back side.

In the conventional light-emitting structure array arrangement illustrated in FIG. 4A, one pixel is composed of three sub-pixels having LEDs 4 for each of the RGB colors (red LED, green LED, and blue LED), and a light-emitting structure is provided for each sub-pixel. Further, openings 20 are formed between adjacent sub-pixels and between adjacent pixels, respectively. In FIG. 4A, an electrode pattern is used when a plurality of LEDs 4 arranged in a line shape are collectively lit (lit all at once), and the openings 20 are formed between lines. The light-shielding layer 11 is not arranged between the anode electrode 2 and the cathode electrode 3, and a part of the back surface of the LED 4 is visible from the back surface of the light-emitting structure through a gap between the anode electrode 2 and the cathode electrode 3. Therefore, light emitted from the back surface of the LED 4 in a direction toward the transparent substrate 1 leaks to the back side through a gap between the anode electrode 2 and the cathode electrode 3.

In the array arrangement of the present embodiment illustrated in FIG. 4B, the light-emitting structure itself is the same as that illustrated in FIG. 4A. That is, one pixel is composed of three sub-pixels having LEDs 4 for each color of RGB, and openings 20 are formed between adjacent sub-pixels, between adjacent pixels, and between lines. In the case of FIG. 4B, the light-emitting structures with leakage reducing function 10 are provided for each sub-pixel. In each light-emitting structure with leakage reducing function 10, the light-shielding layer 11 is arranged in a target region covering a gap between the anode electrode 2 and the cathode electrode 3, whereby light leakage to the back surface can be largely reduced.

Note that although an example of a configuration with a sub-pixel in which three RGB LEDs 4 are arranged in one pixel has been described here, a configuration without a sub-pixel in which one LED 4 is arranged in one pixel may be used.

Here, in order to enhance the effect of reducing light leakage, the target region in which the light-shielding layer 11 is arranged may have a length, in a direction (direction L in the figure) connecting the anode electrode 2 and the cathode electrode 3, that is greater than or equal to the interval between the anode electrode 2 and the cathode electrode 3. However, a length that does not overlap the adjacent target regions is set as an upper limit. That is, a length in which the light shielding layers 11 adjacent in the direction L in FIG. 4B do not overlap each other is set as an upper limit. Further, in the target region in which the light-shielding layer 11 is arranged, a width in a direction (direction W in the figure) orthogonal to the direction connecting the anode electrode 2 and the cathode electrode 3 may be set as a width greater than or equal to the width of the anode electrode 2 and the cathode electrode 3 or the width of the LED 4, whichever is narrower. However, a width that does not overlap the adjacent target regions is set as an upper limit. That is, a width in which the light shielding layers 11 adjacent in the direction W in FIG. 4B do not overlap each other is set as an upper limit.

Although the length of the light-shielding layer 11 in the L direction may be set to be a length that protrudes from the anode electrode 2 and the cathode electrode 3 into the opening 20, and the width of the light-shielding layer 11 in the W direction may be set to be a width that protrudes from the anode electrode 2 and the cathode electrode 3 into the opening 20, in this case, a part of the opening 20 is shielded by the light-shielding layer 11, which lowers the aperture ratio of the pixel. Therefore, it is desirable that the portion of the light-shielding layer 11 that protrudes from the anode electrode 2 and the cathode electrode 3 into the opening 20 is not too wide. Regardless of the length or width of the light-shielding layer 11, it is preferable that the target region in which the light-shielding layer 11 is arranged is a region that does not protrude from the anode electrode 2 and the cathode electrode 3 into the opening 20.

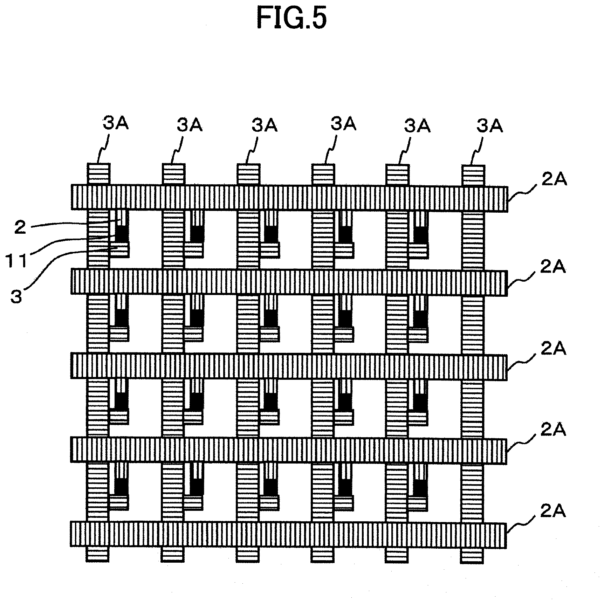

Although FIGS. 4A and 4B illustrate an electrode pattern in the case where a plurality of LEDs 4 arranged in a line shape are lit all at once, it is also possible to apply the light-emitting structure with leakage reducing function 10 of the present embodiment to other electrode patterns. For example, it is also possible to apply this to the case where a plurality of LEDs 4 are arranged in a matrix as illustrated in FIG. 5. In the example of the array arrangement illustrated in FIG. 5, the anode electrode 2 and cathode electrode 3 protruding like branches from the electrodes 2A and 3A intersecting vertically and horizontally are connected to the LEDs 4. Also in this case, the light-shielding layer 11 is arranged in a gap between the anode electrode 2 and the cathode electrode 3.

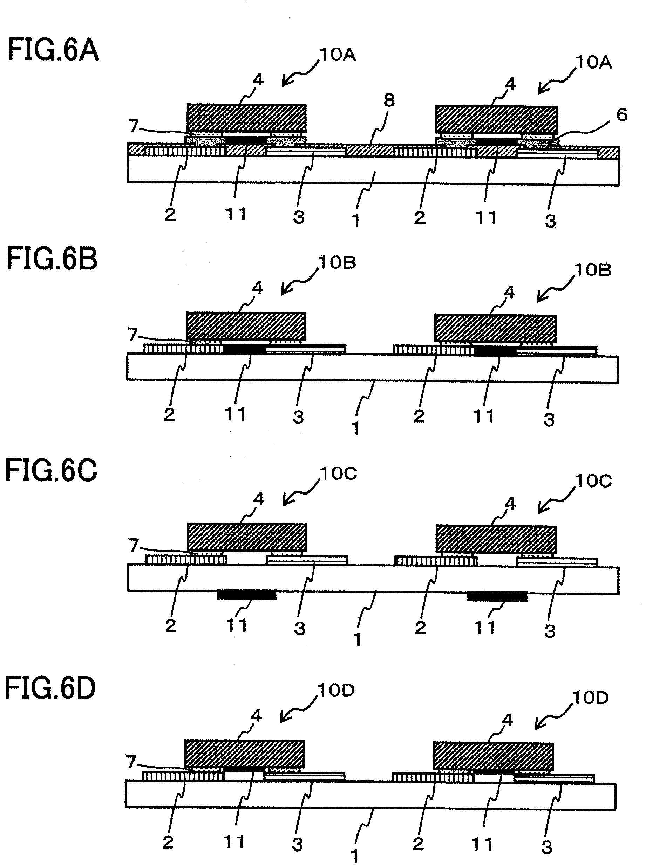

Although FIG. 1 illustrates a configuration in which the target region in which the light-shielding layer 11 is arranged includes a region for shielding the optical path and a region covering the gap between the anode electrode 2 and the cathode electrode 3 on the front side of the gap, the light-shielding layer 11 may be positioned on any layer in the cross section of the light-emitting structure as long as the region includes the region for shielding the optical path. Further, the light-emitting structure to which the light-shielding layer 11 is applied is not limited to that illustrated in FIG. 1. FIGS. 6A to 6D illustrate several modified examples of the light-emitting structure with leakage reducing function provided with the light-shielding layer 11.

FIG. 6A illustrates a configuration example of a light-emitting structure with leakage reducing function 10A in which the light-shielding layer 11 is arranged in a target region to close the gap between the two electrode pads 6 connected to the anode electrode 2 and the cathode electrode 3 in the light-emitting structure in which the electrode pad 6 is made lower in height than the light-emitting structure with leakage reducing function 10 illustrated in FIG. 1 and the second insulating layer 9 is eliminated. Also in this configuration example, the target region in which the light-shielding layer 11 is arranged is a region shielding the optical path and a region to cover the gap between the anode electrode 2 and the cathode electrode 3 on the front side of the gap.

FIG. 6B illustrates a configuration example of a light-emitting structure with leakage reducing function 10B in which the light-shielding layer 11 is arranged in a target region to close the gap between the anode electrode 2 and the cathode electrode 3 in the light-emitting structure in which the contact hole 5, the electrode pad 6, and the insulating layers 8 and 9 illustrated in the light-emitting structure with leakage reducing function 10 illustrated in FIG. 1 are eliminated and the conductive adhesive 7 is directly formed on the anode electrode 2 and the cathode electrode 3 to mount the LED 4. In the light-emitting structure similar to FIG. 1 and FIG. 6A, the light-shielding layer 11 may be arranged in a target region to close the gap between the anode electrode 2 and the cathode electrode 3.

FIG. 6C illustrates a configuration example of a light-emitting structure with leakage reducing function 10C in which the light-shielding layer 11 is arranged on the back surface of the transparent substrate 1 in the light-emitting structure similar to that illustrated in FIG. 6B. In this case, the target region in which the light-shielding layer 11 is arranged includes a region for shielding the optical path and a region covering the gap between the anode electrode 2 and the cathode electrode 3 on the back side of the gap. In the light-emitting structure similar to that in FIGS. 1 and 6A, the light-shielding layer 11 may be arranged on the back side of the transparent substrate 1.

FIG. 6D illustrates a configuration example of a light-emitting structure with leakage reducing function 10D in which the light-shielding layer 11 is arranged on the back side of the LED 4 in the light-emitting structure similar to that in FIG. 6B. In the light-emitting structure similar to that in FIGS. 1 and 6A, the light-shielding layer 11 may be arranged on the back side of the LED 4.

As described above in detail, in the present embodiments, in the light-emitting structure of a transmissive LED display using micro-LED elements, the light-shielding layer 11 is arranged in a target region including a region shielding the optical path, on the optical path in the direction from the back side of the LED 4 facing the gap between the anode electrode 2 and the cathode electrode 3 toward the transparent substrate 1. Thus, when the LED 4 is turned on, the light emitted in the direction from the back side of the LED 4 toward the transparent substrate 1 is shielded by the light-shielding layer 11, so that the light emitted from the LED 4 can be substantially prevented or prevented from leaking to the back side of the display.

Although the structure of applying the light-shielding layer 11 to the transmissive LED display using micro-LED elements has been described in the above embodiments, the light-emitting structure with leakage reducing function of the present embodiments can be applied to any transmission type display having a structure in which the light emitted from the light source leaks through the gap between the electrodes.

All of the above embodiments merely indicate examples of embodiments of the present invention, and the technical scope of the present invention should not be interpreted as being limited. That is, the present invention can be practiced in various forms without departing from the scope of the claims.

## Claims

1. A transmission type display, wherein
a plurality of light sources are arranged between a plurality of sets of electrodes arranged in an array on a transparent substrate, and a plurality of openings where the electrodes are not arranged are provided, so that light is transmittable through the plurality of openings, wherein
a light shielding layer is arranged in a target region including a region shielding an optical path in a direction from a portion of a back surface of the light source facing a gap between the electrodes toward the transparent substrate.

2. The transmission type display according to claim 1, wherein the target region includes the region shielding the optical path and is a region covering the gap between the electrodes.

3. The transmission type display according to claim 1 or 2, wherein the target region has a length in a direction connecting the electrodes that is greater than or equal to an interval between the electrodes and that does not overlap with an adjacent target region.

4. The transmission type display according to one of claims 1 - 3, wherein the target region has a width in a direction orthogonal to the direction connecting the electrodes that is greater than or equal to a width of the electrode or the light source, whichever is narrower and that does not overlap with an adjacent target region.

5. The transmission type display according to one of claims 1 - 4, wherein the target region includes the region shielding the optical path and is a region that closes the gap between the electrodes.

6. The transmission type display according to one of claims 1 - 5, wherein the light shielding layer has an optical density of three or more.

7. The transmission type display according to one of claims 1 - 6, wherein a micro-LED element is used as the light source.
